# EUROPEAN PATENT APPLICATION

(11) **EP 4 421 057 A1**
(43) Date of publication of application: **28.08.2024**
(21) Application number: 24154734.8
(22) Date of filing: 30.01.2024
(51) Int. Cl.: C04B 41/00, C04B 41/45, C04B 41/50, C04B 41/52, C04B 41/85

(54) **HIGH TEMPERATURE METAL CARBIDE COATINGS**

(30) Priority: 22.02.2023 US 202318172810
(71) Applicant: Honeywell International Inc., Charlotte, NC 28202 (US)
(72) Inventor: MEHR, Mehrad, Charlotte, 28202 (US); JADIDIAN, Bahram, Charlotte, 28202 (US)
(74) Representative: Haseltine Lake Kempner LLP

(57) **Abstract**

An example method for forming a high temperature coating includes depositing a carbon layer on to a surface of a composite article using chemical vapor deposition. The composite substrate includes a composite substrate including a carbon matrix. The surface of the composite article includes one or more surface voids. The method further includes applying a metal slurry to the surface of the composite article following the deposition of the carbon layer and reacting a metal of the metal slurry with carbon of the carbon layer to form an antioxidant layer of a metal carbide on the composite article.

## Description

### TECHNICAL FIELD

The disclosure relates to high temperature coatings.

### BACKGROUND

Composites, such as carbon-carbon (C/C) composites, may be used in high temperature applications. For example, the aerospace industry employs C/C composite components as friction materials for commercial and military aircraft, such as brake friction materials. In high temperature applications, C/C composites may be susceptible to oxidation, which may lead to deterioration of physio-mechanical properties.

### SUMMARY

The disclosure describes high temperature coatings for carbon-based composite substrates that protect against oxidation at relatively high temperatures, and techniques for making the same. In some examples, the high temperature coatings include an antioxidant layer of a metal carbide on a surface of a composite articles that includes a composite substrate including a carbon matrix. The surface of the composite article may include surface voids that result from fabrication or machining of the composite substrate. A relatively thin carbon layer may be deposited onto the surface of the composite article using chemical vapor deposition to smooth the surface voids, seal small surface pores, and enhance the formation of a continuous coating. To form the metal carbide, at least a portion of the deposited carbon layer may be reacted with a metal, such as silicon, titanium, or tungsten, in stoichiometric excess. The resulting metal carbide may form a dense antioxidant coating having a high quality, uniform, and continuous crystalline metal carbide that seals the surface defects and is substantially free from surface voids.

In one example, a method for forming a high temperature coating includes depositing a carbon layer on to a surface of a composite article using chemical vapor deposition. The composite article includes a composite substrate that includes a carbon matrix. The surface of the composite article includes one or more surface voids. The method further includes applying a metal slurry to the surface of the composite article following the deposition of the carbon layer and reacting a metal of the metal slurry with carbon of the carbon layer to form an antioxidant layer of a metal carbide on the composite article.

In another example, a high temperature article includes a composite article and a high temperature coating on a surface of the composite article. The composite article includes a composite substrate including a carbon matrix. The high temperature coating comprises an antioxidant layer of a metal carbide on the surface of the composite article. The metal carbide of the antioxidant layer is formed from carbon of a carbon layer deposited using chemical vapor deposition. The antioxidant layer extends across one or more surface voids of the surface of the composite article.

The details of one or more examples of the disclosure are set forth in the accompanying drawings and the description below. Other features, objects, and advantages of the disclosure will be apparent from the description and drawings, and from the claims.

### BRIEF DESCRIPTION OF DRAWINGS

FIG. 1 is a schematic diagram illustrating an example aircraft brake assembly including composite brake disc that include a high temperature coating formed, according to examples of the disclosure.
FIG. 2A is a cross-sectional side view diagram illustrating an example article that includes a high temperature coating, according to examples of the disclosure.
FIG. 2B is a cross-sectional side view diagram illustrating an example article that includes a reactive carbon layer, according to examples of the disclosure.
FIG. 2C is a cross-sectional side view diagram illustrating an example article that includes a high temperature coating, according to examples of the disclosure.
FIG. 3 is a flow diagram illustrating an example technique for forming a high temperature coating, according to examples of the disclosure.
FIG. 4A is a cross-sectional side view diagram illustrating a portion of an example composite article that includes surface voids, according to examples of the disclosure.
FIG. 4B is a cross-sectional side view diagram illustrating the portion of the example composite article of FIG. 4A and a carbon layer, according to examples of the disclosure.
FIG. 4C is a cross-sectional side view diagram illustrating the portion of the example composite article of FIG. 4A, a carbon layer, and a metal slurry, according to examples of the disclosure.
FIG. 4D is a cross-sectional side view diagram illustrating the portion of the example composite article of FIG. 4A and an antioxidant layer, according to examples of the disclosure.
FIG. 4E is a cross-sectional side view diagram illustrating the portion of the example composite article of FIG. 4A, an antioxidant layer, and an outer oxide layer, according to examples of the disclosure.
FIG. 5 is a schematic diagram illustrating an example system for forming a high temperature coating on a composite substrate, according to examples of the disclosure.

### DETAILED DESCRIPTION

The disclosure describes high temperature coatings for composite articles, the composite articles including a carbon-based composite substrate and an antioxidant layer made from a metal carbide for relatively high temperature (e.g., greater than 1500 degrees Celsius (°C)) applications on the composite substrate.

Carbon-based (e.g., including a carbon matrix) composite components, such as carbon-carbon (C/C) composite components, may provide good mechanical properties and have low mass density relative to other materials, such as metal alloys. However, at relatively high temperatures, carbon-carbon composite components may be susceptible to oxidation, environmental attack, and degradation of physio-mechanical properties. Metal carbide-based antioxidant coatings may improve resistance to oxidation and/or environmental attack at high temperatures experienced in aerospace applications, such as aircraft brakes (e.g., temperatures as high as 1600°C), and hypersonic applications, such as leading edges and rocket nozzles.

Prior to use in an oxidizing atmosphere, high temperature carbon-based composite substrates may be coated with a metal carbide-based antioxidant coating that may reduce oxidation of an external surface of the substrate. However, a surface of the composite substrate may include one or more surface voids, such as defects, cracks, pores, ripples, or machining textures, that extend into the substrate. If a metal carbide coating is applied to a surface portion of a composite substrate that includes surface voids, the metal carbide coating may not adequately conform to the surface. Alternatively, if a surface portion of a composite substrate that includes surface voids is reacted with a metal to form a metal carbide coating, the resulting metal carbide coating may not be continuous on the composite substrate. In either case, the underlying composite substrate may be susceptible to oxidation during use in high temperature applications.

In examples described herein, a high temperature coating includes an antioxidant layer that extends across the surface voids of the composite substrate and forms a dense barrier against oxidizing species. An antioxidant layer of the present coatings may include a metal carbide phase formed from a metal, such as silicon, titanium, or tungsten, and reactive carbon from a carbon layer on a surface of the composite substrate. In some examples, prior to reaction with the metal, the reactive carbon layer is deposited onto the surface, including into the surface voids, by chemical vapor deposition (CVD). For example, powders may not bind with the composite substrates, and may only be useful for filling and packing powders into defects until the powders may be converted to a metal carbide. In contrast, CVD processes may form a relatively uniform reactive carbon layer compared to slurry-based methods for depositing carbon powder, and may reduce an amount of labor and/or be more conducive to automation than such slurry-based methods, which may involve carbon powder abrasion or compaction to adequately coat the surface of the composite substrate. Additionally or alternatively, carbon deposited by CVD may inherently bond with the composite substrate very strongly, which may functionally correspond to growing and/or healing the carbon matrix of the composite substrate. The carbon layer may fill small pores (e.g., pores with sizes comparable to the CVD carbon thickness) and smooth out larger pores that may have jagged (high angle and sharp edges) sides. As a result, during reaction with the metal, the carbon of the carbon layer reacts with the metal to form a uniform antioxidant coating that bridges the metal carbide across the surface voids to form a continuous antioxidant coating.

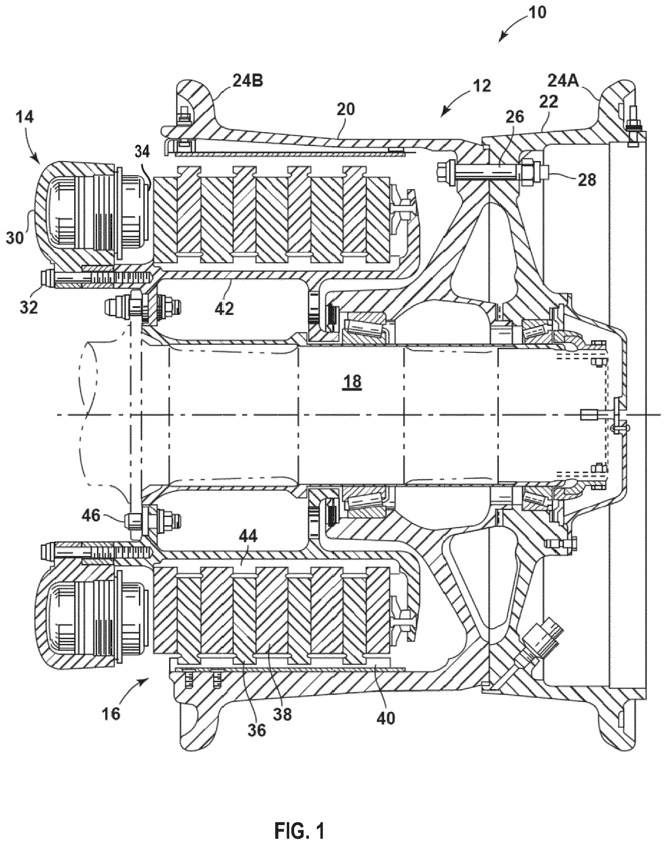

High temperature coatings described herein may be used in a variety of high temperature applications. Due to high temperatures experienced by components in high speed, friction, or combustion environments, the high temperature coatings may be particularly suited to aerospace applications. FIG. 1 is a schematic diagram illustrating an example aircraft brake assembly including composite brake disc that include a high temperature coating formed, according to examples of the disclosure. For ease of description, examples of the disclosure will be described primarily with regard to aircraft brake assemblies. However, the articles of this disclosure may be used to form brake components other than aircraft brake discs, and for applications other than brake components. As one example, the brake components may be used as friction materials in other types of braking applications and vehicles. As another example, the articles may be used for leading edges, hypersonic vehicles or weapons, rocket nozzles, and other application involving high temperatures and oxidizing environments.

In the example of FIG. 1, wheel and brake assembly 10 includes a wheel 12, an actuator assembly 14, a brake stack 16, and an axle 18. Wheel 12 includes wheel hub 20, wheel outrigger flange 22, bead seals 24A and 24B, lug bolt 26, and lug nut 28. Actuator assembly 14 includes actuator housing 30, actuator housing bolt 32, and ram 34. Brake stack 16 includes alternating rotor brake discs 36 and stator brake discs 38; rotor brake discs 36 are configured to move relative to stator brake discs 38. Rotor brake discs 36 are mounted to wheel 12, and in particular wheel hub 20, by beam keys 40. Stator brake discs 38 are mounted to axle 18, and in particular torque tube 42, by splines 44. Wheel and brake assembly 10 may support any variety of private, commercial, or military aircraft or other type of vehicle.

Wheel and brake assembly 10 includes wheel 12, which in the example of FIG. 1 is defined by a wheel hub 20 and a wheel outrigger flange 22. Wheel outrigger flange 22 may be mechanically affixed to wheel hub 20 by lug bolts 26 and lug nuts 28. Wheel 12 defines bead seals 24A and 24B. During assembly, an inflatable tire (not shown) may be placed over wheel hub 20 and secured on an opposite side by wheel outrigger flange 22. Thereafter, lug nuts 28 can be tightened on lug bolts 26, and the inflatable tire can be inflated with bead seals 24A and 24B providing a hermetic seal for the inflatable tire.

Wheel and brake assembly 10 may be mounted to a vehicle via torque tube 42 and axle 18. In the example of FIG. 1, torque tube 42 is affixed to axle 18 by a plurality of bolts 46. Torque tube 42 supports actuator assembly 14 and stator brake discs 38. Axle 18 may be mounted on a strut of a landing gear (not shown) or other suitable component of the vehicle to connect wheel and brake assembly 10 to the vehicle.

During operation of the vehicle, braking may be necessary from time to time, such as during landing and taxiing procedures of an aircraft. Wheel and brake assembly 10 is configured to provide a braking function to the vehicle via actuator assembly 14 and brake stack 16. Actuator assembly 14 includes actuator housing 30 and ram 34. Actuator assembly 14 may include different types of actuators such as one or more of, e.g., an electrical-mechanical actuator, a hydraulic actuator, a pneumatic actuator, or the like. During operation, ram 34 may extend away from actuator housing 30 to axially compress brake stack 16 against a compression point for braking.

Brake stack 16 includes alternating rotor brake discs 36 and stator brake discs 38. Rotor brake discs 36 are mounted to wheel hub 20 for common rotation by beam keys 40. Stator brake discs 38 are mounted to torque tube 42 by splines 44. In the example of FIG. 1, brake stack 16 includes four rotors and five stators. However, a different number of rotors and/or stators may be included in brake stack 16 in other examples.

In some examples, rotor brake discs 36 and stator brake discs 38 may be mounted in wheel and brake assembly 10 by beam keys 40 and splines 44, respectively. In some examples, beam keys 40 may be circumferentially spaced about an inner portion of wheel hub 20. Beam keys 40 may, for example, be shaped with opposing ends (e.g., opposite sides of a rectangular) and may have one end mechanically affixed to an inner portion of wheel hub 20 and an opposite end mechanically affixed to an outer portion of wheel hub 20. Beam keys 40 may be integrally formed with wheel hub 20 or may be separate from and mechanically affixed to wheel hub 20, e.g., to provide a thermal barrier between rotor brake discs 36 and wheel hub 20. Toward that end, in different examples, wheel and brake assembly 10 may include a heat shield (not shown) that extends out radially and outwardly surrounds brake stack 16, e.g., to limit thermal transfer between brake stack 16 and wheel 12.

In some examples, splines 44 may be circumferentially spaced about an outer portion of torque tube 42. As such, stator brake discs 38 may include a plurality of radially inwardly disposed lug notches along an inner diameter of the brake disc configured to engage with splines 44. Similarly, rotor brake discs 36 may include a plurality of radially inwardly disposed lug notches along an outer diameter of the brake disc configured to engage with beam keys 40. As such rotor brake discs 36 will rotate with the motion of the wheel while stator brake discs 38 remain stationary allowing the friction surfaces of an adjacent stator brake disc 38 and rotor brake disc 36 to engage with one another to deaccelerate the rotation of wheel 12.

Rotor brake discs 36 and stator brake discs 38 may provide opposing friction surfaces for braking an aircraft. As kinetic energy of a moving aircraft is transferred into thermal energy in brake stack 16, temperatures may rapidly increase in brake stack 16. As such, rotor brake discs 36 and stator brake discs 38 that form brake stack 16 may include coatings capable of operating at very high temperatures and blocking various oxidizing species.

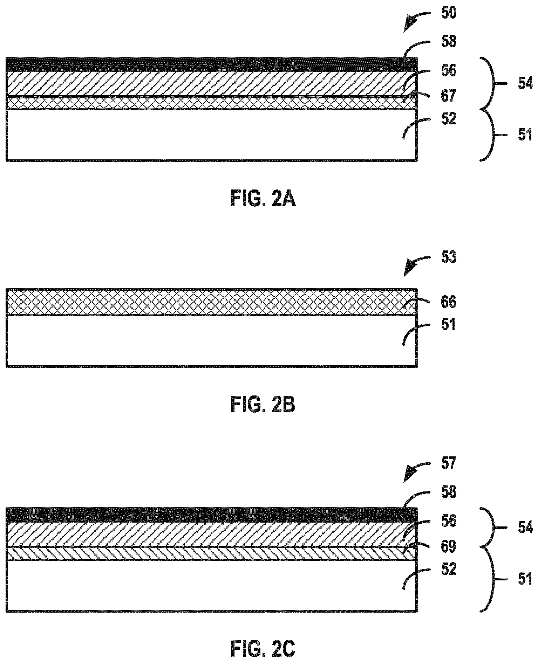

In some examples, articles or components, such as brake discs 36 and/or 38 of FIG. 1 described above, include a high temperature coating to protect an underlying substrate from oxidation, such as non-friction surfaces of brake discs. Non-friction surfaces of brake discs 36 may include those surfaces of brake discs 36 that do not engage another opposing surface during, e.g., a braking operation of assembly 10 when the friction surfaces of brake discs 36 are engaged. FIG. 2A is a cross-sectional side view diagram illustrating an example high temperature article 50 that includes a high temperature coating 54, according to examples of the disclosure. In some examples, article 50 is a brake disc but can be another article in other examples.

High temperature article 50 includes a composite article 51 that includes a carbon-based composite substrate 52. In the example of FIG. 2A, composite article 51 only includes substrate 52, such that an outer surface of substrate 52 defines an outer surface of composite article 51; however, as will be described in FIG. 2C below, composite article 51 may include one or more additional layers at least partially defining a surface of composite article 51.

Substrate 52 may include reinforcement fibers and a carbon-based matrix (or "carbon matrix") material at least partially surrounding the reinforcement fibers. In some examples, substrate 52 may be a carbon-carbon (C/C) composite substrate that includes carbon-based reinforcement fibers and a carbon-based matrix material at least partially surrounding the carbon-based reinforcement fibers. In such examples, substrate 52 may be formed form a porous preform that includes carbon-based reinforcement fibers or carbon-precursor reinforcement fibers. Examples of porous preforms that may be used to produce substrate 52 include, but are not limited to: a fibrous preform, such as a woven fiber preform, a nonwoven fiber preform, a chopped-fiber and binder preform, a binder-treated random fiber preform, a carbon fiber preform, or a ceramic fiber preform; a foam preform; a porous carbon body preform; or a porous ceramic body preforms.

In some examples, the porous preform includes a plurality of mechanically bound layers, which can be, for example, a plurality of fibrous layers, such as a plurality of woven or nonwoven fabric layers, connected together, e.g., bound by a binder, such as a resin binder, or via needle-punching of the plurality of layers. In some examples, the layers include one or more tow layers, one or more web layers, or combinations thereof. Tow layers may include one or more tows of fibers. Tows of fibers may be arranged in any suitable arrangement including, for example, linear, radial, chordal, or the like. Web layers may include web fibers, which may include relatively short, chopped, and entangled fibers of fibers. In other examples, the porous preform may not include predefined layers, but, rather, may be formed from a bundle of fibers that are mechanically bound together, e.g., via needling. In other examples, a combination of any of the aforementioned types of porous preforms can be used.

Substrate 52 includes a carbon matrix material that at least partially encapsulates the reinforcement fibers. The matrix material may be introduced into the reinforcement fibers, such as a porous preform, using one or more of a variety of techniques, including, for example, chemical vapor deposition/chemical vapor infiltration (CVD/CVI), resin transfer molding (RTM), vacuum/pressure infiltration (VPI), high pressure impregnation/carbonization (PIC), or the like. The carbon matrix may have a microstructure that reflects the particular conditions of formation, such as deposition conditions used to form the carbon matrix and composition and/or orientation of the reinforcement fibers. For example, different growth conditions between two carbon materials may result in discontinuities between different microstructures, such that the presence of the discontinuities may indicate the presence of different growth conditions. For example, a carbon matrix that forms via CVD/CVI around fibers of a composite substrate may form relatively slow and infiltrate the porosity of the fibers, while a carbon surface layer that forms via CVD on a surface may form relatively quickly and fill only surface pores before forming a dense outer layer. As a result, the crystallinity, density, microstructure, and other characterization signatures, like Raman spectra, may be different between the carbon matrix of the composite substrate and the carbon matrix of the surface layer. The microstructure of a carbon matrix formed from a particular fabrication method under particular fabrication conditions may have particular structural properties including, but not limited to, porosity; matrix phase composition, such as interbundle and/or interfilament phases; microcracking; interface presence and orientation, such as grains; or other structural properties that result from a mechanism of formation within and/or around the reinforcement fibers.

A surface of composite article 51 may include one or more surface voids. In examples in which substrate 52 is an outermost portion of article 51, such as illustrated in FIG. 2A, substrate 52 may include one or more surface voids. For example, article 51 may include surface voids that extend from an outer surface of article 51 into a bulk of article 51. Surface voids may include defects such as cracks, inherent structures such as surface pores, or other voids or roughness in the surface that extend into article 51 and may have relatively complex or irregular surfaces. For example, during machining of a surface of substrate 52, pore structures previously embedded in a bulk of substrate 52 may be exposed at a surface of substrate 52 through material removal.

Substrate 52 may be subject to high temperatures during operation. As one example, carbon-carbon composite brake discs may be subject to temperatures as high as about 3,000 degrees Fahrenheit (°F) (about 1,649°C) during braking events. About may be, for example, exactly or nearly exactly to the extent permitted by manufacturing, measurement, and/or operational tolerances, or within 1%, 2%, 3%, 4%, or 5% of the value. To protect substrate 52 from oxidation, article 50 includes a high temperature coating 54 on one or more surfaces of substrate 52. Coating 54 may be stable at temperatures of up to about 3600°F (about 2000°C). In this context, "stable" may mean that coating 54 does not degrade into its constituent elements, does not react with carbon, and/or does not react with other elements or compounds present in the environment in which coating 54 is used including, but not limited to, oxidation, for a period of time (e.g., minutes or hours). Coating 54 may have any suitable thickness. In some examples, a thickness of coating 54 may be about 1 micrometer (µm) to about 100 µm. In some examples, a thickness of coating 54 may be self-terminating and determined by diffusion properties of the metal carbon system and/or deposition properties of the carbon layer.

High temperature coating 54 includes an antioxidant layer 56 on a surface of substrate 52. Antioxidant layer 56 includes a metal carbide. Metal carbides may have high strength, wear-resistance, and temperature resistance, and may be chemically compatible with underlying substrate 52. In some examples, the metal carbide includes at least one of silicon carbide, titanium carbide, or tungsten carbide.

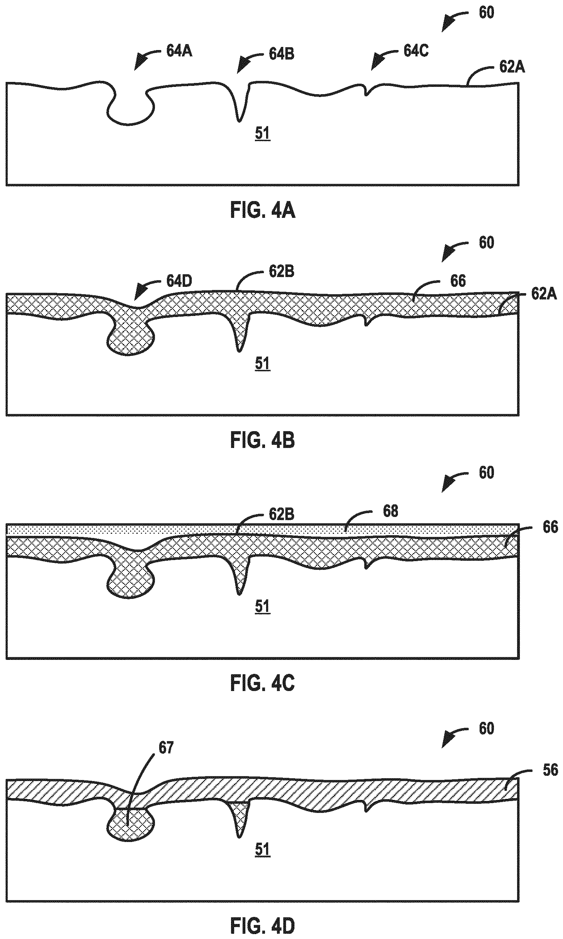

Surface voids, such as defects or pores, on the surface of substrate 52 may cause discontinuities to form in a metal carbide layer that is either applied to a surface of substrate 52 or formed from a surface portion of substrate 52, and thereby permit oxidizing species to react with the underlying substrate 52. As will be explained further in FIGS. 4A-4E below, an antioxidant layer - in the example of FIG. 2A, layer 56 - extends across one or more surface voids on the surface of substrate 52 to form a uniform, defect-free, and continuous layer that substantially encapsulates substrate 52.

In some examples, antioxidant layer 56 is formed by reacting a metal, such as in a metal slurry, with a carbon layer that extends across the surface of substrate 52, including into the surface voids. As a result, portions of antioxidant layer 56 may extend across and substantially seal surface voids (e.g., seal all surface voids or nearly all surface voids, such as 90% or more, or 95% or more, or 99% or more of the surface voids) in the surface of substrate 52 to form a substantially continuous coating. FIG. 2B is a cross-sectional side view diagram illustrating an example intermediate article 53 that includes a reactive carbon layer 66, according to examples of the disclosure.

Carbon layer 66 is formed by chemical vapor deposition (CVD). Chemical vapor deposition processes for forming carbon layer 66 may include any process in which gaseous carbon precursors decompose to form solid carbon. In contrast to slurry-based processes for forming carbon deposits, which may cause significant variations in layer thickness and composition, or physical vapor deposition (PVD) processes, which may be limited by line-of-sight, CVD processes may enable greater control of thickness and composition of carbon layer 66 and greater infiltration of carbon layer 66 into surface voids. For example, a thickness and composition of carbon layer 66 may be controlled by controlling a rate of decomposition of the carbon precursors, and infiltration of carbon layer 66 into surface voids may be driven by diffusion or mixing. As a result, carbon layer 66 may provide a uniform reactive portion of carbon for subsequent reaction with a metal to form a metal carbide. A variety of carbon precursors may be used to form carbon layer 66 including, but not limited to, hydrocarbons, such as methane, acetylene, ethylene, propylene, benzene, toluene, and xylene; and any other carbon compound that may decompose from a gas to form solid carbon. Carbon precursors may be selected based on various properties of carbon layer 66 and conditions of the CVD process.

Carbon layer 66 may have a different microstructure than the carbon matrix of substrate 52. For example, carbon layer 66 may be formed under particular CVD conditions, such as temperature and pressure, that result in different structural properties of a surface portion of the carbon matrix of substrate 52, including a carbon matrix formed by CVI. As such, carbon layer 66 may be structurally differentiated from the carbon matrix of substrate 52.

In some examples, carbon layer 66 may have a relatively smooth surface compared to an underlying surface of article 51. Surface voids in the surface of article 51 may define a roughness of the surface, such that an applied silicon carbide coating (e.g., via slurry) may not adhere to all or part of the surface or may have a low thickness in areas of peaks and high thickness or voids in areas of troughs. While abrasive techniques, such as polishing, may reduce the roughness of the surface, such abrasive techniques may be labor intensive and difficult to automate. By using CVD processes to deposit carbon layer 66, carbon forming carbon layer 66 may deposit into surface voids and form a smoother surface for reaction with the metal without mechanical additive (e.g., compaction) or subtractive (e.g., polishing) processes. A rough surface may be characterized by displacement or angular deviations from a general surface plane. Surface roughness may be characterized in any of a variety of ways including, but not limited to, average profile height deviation, average trough depth, average peak height, average peak to trough height, average profile angle, or any other measure of surface roughness. In some examples, a surface roughness of the surface of carbon layer 66 may be less than half the surface roughness of the surface of substrate 51.

Carbon layer 66 may have a thickness that is sufficiently high to provide a smoother surface than article 51 and/or provide enough reactive carbon to form a robust antioxidant layer 56 of silicon carbide. For example, carbon layer 66 may have a thickness such that carbon fills and/or seals defects in the surface of substrate 51 and may be reacted with the metal to form a metal carbide having a minimum thickness. Carbon layer 66 may have a thickness that is sufficiently low to reduce an amount of unreacted carbon in carbon layer 66 (e.g., less than about 50 percent by volume of the total volume of carbon layer 66). For example, as will be explained further below, a thickness of the metal carbide formed from carbon layer 66 may be limited by formation of the metal carbide, which may prevent the metal from further infiltrating into carbon layer 66. In some examples, a thickness of carbon layer 66 may be greater than or equal to about 2 micrometers and/or less than or equal to about 100 micrometers, such as from about 5 micrometers to about 10 micrometers.

In some examples, carbon layer 66 has a minimum thickness. For example, CVD processes for forming carbon layer 66 may deposit carbon at a relatively uniform rate across the surface of article 51, such that carbon layer 66 may have a controllable minimum thickness across the surface of article 51. A thickness of carbon layer 66 may vary depending on a location on substrate 52, how CVD gases are introduced into a reactor, and other factors or operating parameters of CVD. A desired minimum thickness may correspond to a thickness that enables a smooth shell that cover surface defects, such that the minimum thickness may correspond to an underlying surface roughness and a depth of various defects on substrate 52. In contrast, a thickness of a resulting metal carbide formed from carbon layer 66 may be thermodynamically determined and self-terminating, and may be independent of a thickness of carbon layer 66 or various operating parameters of CVD. In some examples, a minimum thickness of carbon layer 66 may be at least 5 micrometers.

In some examples, carbon layer 66 may have a substantially uniform composition and morphology. For example, prior to reaction with a metal, at least a surface portion of carbon layer 66 (e.g., outer-most 10-20 microns) includes carbon that is capable of reacting with the metal to form a metal carbide. The carbon of the surface portion of carbon layer 66 may have a substantially uniform composition and/or morphology, such as microstructure, phase composition, geometry of component phases, morphology of components phases, crystal structure, presence and type of impurities, particle morphology shape and size, crystal surface terminations (e.g., active facets), crystal defects, and/or surface functionalization.

The particular composition and/or morphology may result in a reaction with the metal according to particular reaction thermodynamics and kinetics, such as a temperature of reaction and a rate of reaction. As a result of a substantially uniform composition and/or morphology, carbon layer 66 may have a substantially uniform reaction thermodynamics and kinetics across carbon layer 66. By forming a metal carbide formed from a deposited carbon layer having a substantially uniform composition and/or morphology, antioxidant layer 56 may be formed at substantially the same time and rate, thereby bridging the resultant metal carbide across the surface voids.

In some examples, additional antioxidant layers may be formed on antioxidant layer 56 to increase an overall thickness of antioxidant layers on substrate 52. For example, powder-based carbon applications may not include multiple antioxidant layers, as carbon powder may only be provided to a surface prior to forming an outermost antioxidant layer. In contrast, carbon layer 66 formed by CVD may provide a solid layer of carbon, such that additional carbon layers 66 be added on antioxidant layer 56 and subsequently converted to metal carbide to overcome a self-terminating thickness limit and make thicker coatings.

As will be described further in FIGS. 4A-4E below, an amount of carbon in carbon layer 66 that may be reacted with a metal may be limited by an extent of infiltration of the metal into carbon layer 66. For example, to form the metal carbide, the metal may infiltrate into carbon layer 66 to a particular depth and react with the carbon to form the metal carbide. The extent to which the metal may infiltrate into carbon layer 66 may be limited by formation of the metal carbide, which may act as a barrier for further infiltration of the metal. As such, one or more portions of carbon layer 66 near a surface of substrate 52 may remain unreacted. Referring back to FIG. 2A, in some examples, high temperature coating 54 includes an unreacted carbon layer 67 overlying substrate 52 and underlying antioxidant layer 56. A thickness of carbon layer 67 may be related to a corresponding thickness of carbon layer 66. As described above, carbon layer 66 may be deposited to at least a minimum thickness across the surface of substrate 52. However, surface voids in the surface of substrate 52 may result in a surface profile of the surface of carbon layer 66 changing through the CVD process, resulting in a varying thickness. As a result, portions of carbon layer 66 having a greater thickness, such as portions near troughs in the surface of substrate 52, may include portions of unreacted carbon layer 67.

In some examples, antioxidant layer 56 is metal-rich, such that antioxidant layer 56 may include a metal carbide having metal in stoichiometric excess. For example, during formation of the metal carbide from the carbon of carbon layer 66, a portion of excess metal may remain in antioxidant layer 56. During operation of article 50, the metal may form a metal oxide that may migrate to form a passivation layer, such as an outer layer 58 described below, or may fill small cracks or pores in antioxidant layer 56 caused by a difference in coefficient of thermal expansion between substrate 52 and antioxidant layer 56, such as by expanding through oxidation of the excess metal at high temperatures in the presence of oxidation during operation. As a result, the metal of antioxidant layer 56 may perform a passivation and/or self-healing function to further protect substrate 52.

In some examples, coating 54 includes an outer layer 58 of a metal oxide on antioxidant layer 56. For example, metal that reacts with the carbon of carbon layer 66 during formation of antioxidant layer 56 may be applied to the surface of carbon layer 66 as metal powder or particles. This metal powder may include metal oxide surface layers that form in an oxidizing atmosphere, such as an oxide of the underlying metal or an oxide of a different element. For example, the metal oxide surface layers may have a thickness of about 1 nanometer to about 1 micrometer. During formation of antioxidant layer 56, the metal oxides may migrate to a surface of antioxidant layer 56 and form outer layer 58. Outer layer 58 may have a relatively high temperature resistance, such as greater than about 1500°C. In this way, metal oxides that may otherwise be present in the metal powder as impurities may form a further protective layer to protect substrate 52 from oxidation.

While FIGS. 2A and 2B have been described with respect to a carbon layer formed directly on a composite substrate, in some examples, the carbon layer is formed on another antioxidant layer formed from a surface portion of the composite substrate. FIG. 2C is a cross-sectional side view diagram illustrating an example article 57 that includes a high temperature coating 54, according to examples of the disclosure. Article 51 includes substrate 52 and a first antioxidant layer 69 overlying substrate 52. High temperature coating 54 may include a second antioxidant layer 56 overlying first antioxidant layer 69, and an optional outer layer 58 overlying second antioxidant layer 56. Second antioxidant layer 56 may be formed from carbon in carbon layer 66, such as described in FIG. 2A above, while first antioxidant layer 69 may be formed from a carbon matrix of composite substrate 52.

First antioxidant layer 69 may include a metal carbide that is formed from the carbon matrix of a surface portion of composite substrate 52. For example, prior to reaction with a metal, substrate 52 may include a surface portion (e.g., outer-most 10-20 microns) that includes carbon matrix capable of reacting with a metal to form a metal carbide. First antioxidant layer 69 may include one or more substantially crystallized (e.g., greater than 95% by volume crystalline phase) metal carbide layers. In some examples, first antioxidant layer 69 may include at least one of silicon carbide (SiC), titanium carbide (TiC), tungsten carbide (WC), zirconium carbide (ZrC), combinations thereof, or any carbide layer formed using the principles of the process described in U.S. Patent No. 6,555,173 and/or U.S. Patent No. 4,837,073, which are incorporated by reference herein in their entirety.

In some examples, first antioxidant layer 69 may be configured to increase adhesion between second antioxidant layer 56 and substrate 52. For example, first antioxidant layer 69 may be formed from an *in situ* process that involves reaction between reactive carbon in the carbon matrix of a surface portion of substrate 52 and metal. In some examples, inclusion of first antioxidant layer 69 and second antioxidant layer 56 may provide multiple stages of reduction of surface defects in substrate 52. For example, first antioxidant layer 69 may reduce a number and/or extent of surface defects in substrate 52, such that second antioxidant layer 56 may further reduce the remaining surface defects.

In some examples, the metal may be in stoichiometric excess, and may form a metal oxide that may migrate into microcracks of substrate 52, first antioxidant layer 69, and/or second antioxidant layer 56 to provide a self-healing functionality. The metal oxide may more strongly adhere to the silicon carbide matrix of second antioxidant layer 56, and/or may be at least partially impregnated into open pores of substrate 52. Additionally or alternatively, second antioxidant layer 56 may have a relatively low thickness, such as less than about 20 micrometers, and/or consistent thickness, such as within about 10 micrometers, that is controlled by an amount of reactive carbon present on substrate 52.

Second antioxidant layer 56 may be formed on first antioxidant layer 69 via reactive carbon layer 66. As described in FIG. 2B above, carbon layer 66 may have a different microstructure than the carbon matrix of substrate 52. As such, a metal carbide of first antioxidant layer 69 formed from the carbon matrix of substrate 52 may be different from a metal carbide of second antioxidant layer 56 formed from carbon layer 66, such that first antioxidant layer 69 may be structurally differentiated from second antioxidant layer 56.

In some examples, carbon layer 66 may have a lower porosity than the carbon matrix of substrate 52, such that second antioxidant layer 56 may form a more protective barrier than first antioxidant layer 69. For example, carbon deposited by CVD on a surface may be denser than carbon deposited by chemical vapor infiltration or slurry infiltration on a porous preform. As a result, a silicon carbide formed from carbon layer 66 may have a lower porosity than a silicon carbide formed from the carbon matrix of a surface portion of composite substrate 52.

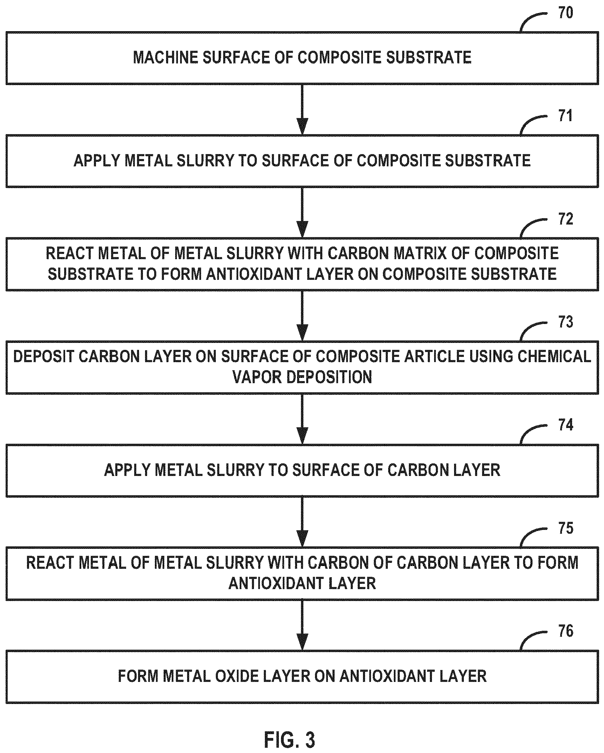

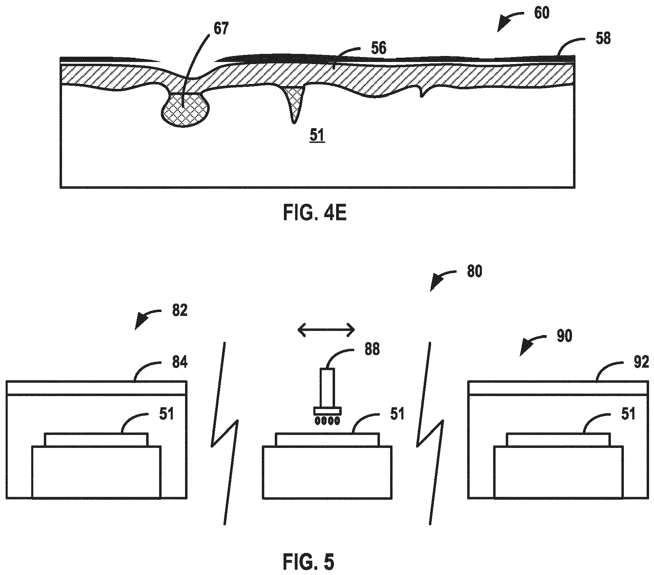

High temperature antioxidant coatings described herein, such as coating 54 of FIG. 2A or FIG. 2C above, may be formed *in situ* on composite substrates to form dense coatings that may continuously encapsulate the composite substrate. FIG. 3 is a flow diagram illustrating an example technique for forming a high temperature coating, according to examples of the disclosure. The example technique of FIG. 3 will be described with respect to FIGS. 4A-4E, which illustrate various steps for forming high temperature antioxidant coatings, and FIG. 5, which illustrates an example system or sequence of systems for forming a high temperature coating.

The example technique of FIG. 3 may include machining a surface of a composite substrate (70), such as substrate 52 of FIG. 2A. Machining may include any mechanically subtractive process that modifies dimensions of substrate 52. For example, a porous fiber preform may be infiltrated with carbon to form a carbon matrix and, correspondingly, an infiltrated composite substrate to a set of initial dimensions. One or more surfaces of the infiltrated composite substrate may be machined to form substrate 52 having a final set of dimensions prior to forming a protective coating (e.g., coating 54). However, such machining may form a surface of substrate 52 that includes one or more surface voids. In other examples, substrate 52 may not be machined, but still may include surface voids that may inhibit adhesion or mechanical stability of a coating formed on or from substrate 52.

In some examples, prior to depositing a carbon layer on the composite article, an antioxidant layer may be formed on the composite substrate. In such examples, the example technique of FIG. 3 may include applying a metal slurry to a surface of the composite substrate (71) and reacting metal of the metal slurry with the carbon matrix of a surface portion of the composite substrate to form an antioxidant layer on the composite substrate (72). For example, as described in FIG. 2C, first antioxidant layer 69 may be formed from carbon of the carbon matrix, such that first antioxidant layer 69 may define at least a portion of a surface of article 51. As a result, article 51 may include an antioxidant layer that includes a metal carbide on a surface of the composite substrate.

Regardless of whether substrate 52 is machined or whether article 51 includes substrate 52 alone or additional surface layers, article 51 may include various surface voids that, if left unsealed or partially sealed, may permit oxidizing species to penetrate into and react with substrate 52. FIG. 4A is a cross-sectional side view diagram illustrating a portion 60 of an example article 51, according to examples of the disclosure. Article 51 defines an initial outer surface 62A. Surface 62A includes one or more surface voids 64A, 64B, 64C (individually "void 64" and collectively "voids 64"). Voids 64 may include any irregularity or deviation from a general plane of surface 62A that may otherwise produce a discontinuity in a metal carbide coating unless filled. For example, a pore having high curvature may result in inhibited reaction with a metal, and thus may be a void 64 to be filled, while a shallow depression having low curvature may not result in inhibited reaction with an infiltrated metal, and thus may not be a void 64 to be filled. In some examples, voids 64 may include one or more pores 64A, one or more cracks 64B, and/or one or more surface projections or depressions 64C. These voids 64 may be formed during formation of substrate 52, and manufacturing efforts to reduce voids 64 may be relatively expensive. Voids 64 may have relatively complex surfaces that define relatively complex volumes that may be difficult to fill. For example, relatively large reactant particle size and/or high slurry viscosity may limit penetration of metal reactants into voids 64. In some examples, a size of surface voids 64 are greater than about 100 µm, such as, but not limited to, about 100 µm to about 1000 µm.

Referring back to FIG. 3, the example technique includes depositing a carbon layer on a surface of the composite article using chemical vapor deposition (73). Depositing the carbon layer on the surface may include positioning the article in a reaction chamber, introducing a carbon precursor to an atmosphere in contact with the surface of the article, and creating operating conditions, such as temperature and/or pressure conditions, that are configured to decompose the carbon precursor to form a carbon layer. Various operating parameters of CVD may include, but are not limited to, temperature, pressure, precursor/gas inflow, precursor type (e.gg, methane, other hydrocarbons, or carbon source). Microstructural properties of the carbon layer that may result from controlling the various operating parameters include, but are not limited to, good bonding (e.g., surface conformance, adhesion, etc.) to the surface, uniformity of thickness, bridging of defects and voids, smooth surface, fast coating time, and the like.

FIG. 4B is a cross-sectional side view diagram illustrating portion 60 of the example article 51 of FIG. 4A and a carbon layer 66, according to examples of the disclosure. Depositing carbon layer 66 on surface 62A may include depositing carbon on exposed portions of surface 62A, including surfaces within voids 64 (e.g., at least partially fill the surface voids with carbon), such that carbon may penetrate into surface voids 64 and extend across surface voids 64. Carbon may be deposited until a desired thickness of carbon layer 66 is reached.

In some examples, depositing the carbon of carbon layer 66 includes introducing a gaseous carbon precursor, optionally including a carrier gas, to an environment near surface 62A and maintaining deposition conditions of the gaseous carbon precursor to cause the gaseous carbon precursor to decompose and deposit on surface 62A and/or a new or intermediate surface 62B of carbon layer 66. Maintaining deposition conditions of the gaseous carbon precursor may include maintaining a temperature of the gaseous carbon precursor above a decomposition temperature of the gaseous carbon precursor to decompose the gaseous carbon precursor into carbon and a byproduct gas, such as hydrogen. Maintaining deposition conditions of the gaseous carbon precursor may further include controlling the temperature and pressure of the gaseous carbon precursor to achieve a particular deposition rate of carbon. For example, a higher temperature and lower pressure may increase a rate of decomposition of the gaseous carbon precursor and subsequent deposition of the carbon, but may result in carbon layer 66 having a higher amorphous phase than deposition conditions that include a lower temperature and/or higher pressure.

A variety of parameters, such as a temperature of gaseous carbon precursor, a pressure of gaseous carbon precursor, a concentration of gaseous carbon precursor, and a time of deposition, may be controlled to maintain the gaseous carbon precursor above deposition conditions, and optionally encourage controlled deposition of the carbon into carbon layer 66. As one example, for a carbon precursor gas of methane, the temperature may be maintained greater than or equal to about 800°C, the pressure may be maintained at about 0.005 Torr to about 20 Torr, and the temperature and pressure may be maintained for greater than or equal to about one hour.

Carbon layer 66 may form new surface 62B of portion 60. After deposition of carbon layer 66, surface 62B of carbon layer 66 may be smoother than surface 62A of article 51. For example, as shown in FIG. 4B, carbon may be continually deposited on exposed surfaces of carbon layer 66 until voids 64 are filled and/or carbon layer 66 extends across voids 64. In the example of FIG. 4B, a void 64D defined by surface 62B may be smaller than void 64A. While in the example of FIG. 2B, all voids 64 are filled with carbon layer 66, in some examples, portions of voids 64 may remain unfilled, but covered by carbon layer 66.

In some examples, carbon layer 66 has a substantially uniform composition and morphology across surface 62B. For example, the microstructure and/or crystallinity of carbon layer 66 may be substantially the same at various portions of carbon layer 66, and so may have a substantially same reaction thermodynamics and kinetics across carbon layer 66, such that reaction of an infiltrated metal with carbon layer 66 may occur at substantially the same temperature and substantially the same rate across carbon layer 66. As explained above, reaction thermodynamics and kinetics of carbon layer 66 may be a product of a respective type, feedstock source, processing history, and other properties and conditions of carbon layer 66 that influence a temperature and rate at which carbon layer 66 may react with an infiltrated metal. The resulting carbon layer 66 may have a uniform composition and morphology, may be generated proximate to voids 64, and may penetrate into voids 64 without the use of a carrier medium.

Referring to FIG. 5, an example system 80 includes a chemical vapor deposition system 82 configured to deposit a carbon layer on article 51. System 82 may include an enclosed chamber configured to introduce gaseous carbon precursors to a surface of article 51 and maintain deposition conditions, such as pressure and temperature, of the gaseous carbon precursor, such that the gaseous carbon precursor decomposes and forms carbon layer 66.

Referring back to FIG. 3, the example technique includes applying a metal slurry to the surface of the composite article (74). FIG. 4C is a cross-sectional side view diagram illustrating portion 60 of the example article 51 of FIG. 4A, carbon layer 66, and a metal slurry 68 on article 51, according to examples of the disclosure. While illustrated as a metal slurry 68, the metal may be applied in any form, including as a liquid or gas.

Metal slurry 68 may include metal particles in an application medium. In some examples, the metal particles of metal slurry 68 include at least one of silicon, titanium, or tungsten. The metal particles may be coated by a thin layer of a metal oxide, such as may be formed in an oxidizing atmosphere during formation or shelf-life of the metal particles. For example, a relatively pure feedstock of metal particles may be prohibitively expensive due to inert storage, such that use of metal particles that include a metal oxide film may broaden available feedstocks of material for the metal particles and/or reduce a cost of the metal particles.

Referring to FIG. 5, system 80 may include a metal application system 88. Metal application system 88 is configured to apply the metal slurry to a surface of article 51. While illustrated in FIG. 5 as a spray system, metal application system 88 may include any system configured to apply a metal slurry to the surface of article 51, such as a brush system.

Referring back to FIG. 3, the example technique includes reacting a metal of the metal slurry with carbon of the carbon layer to form an antioxidant layer of a metal carbide on the composite article (75). FIG. 4D is a cross-sectional side view diagram illustrating portion 60 of the example article 51 of FIG. 4A and an antioxidant layer 56, according to examples of the disclosure. To react the metal of metal slurry 68 with the carbon of carbon layer 66, the metal may be fluidized (e.g., melted or sublimated) such that the metal may infiltrate into carbon layer 66 and react with carbon of carbon layer 66 to form a metal carbide. This metal carbide may form a continuous antioxidant layer 56 to substantially seal substrate 52.

In some instances, this reaction may be limited by diffusion of the metal into the carbon layer 66. As the metal reacts with the carbon of carbon layer 66 and forms a metal carbide, the newly formed metal carbide may form a diffusion barrier separating the reactants (e.g., carbon and metal), which may stop the thickening and further creation to form thicker metal carbides (e.g., by preventing metal from further penetrating into a depth of carbon layer 66 and/or preventing diffusion of carbon out of carbon layer 66 to react with the metal). The metal may be applied to surface 62B of carbon layer 66 until the reaction ends either by diffusion limitation, metal evaporation or exhaustion, or both. For example, any remaining metal on surface 62 may be removed, such as through evaporation. The resulting layer 56 may be a relatively homogeneous metal carbide having a relatively uniform thickness that may include some deviations to fill voids 64. In some examples, a thickness of antioxidant layer 56 at a surface of article 51 is less than about 50 microns, such as about 10 microns to about 20 microns.

Reaction of the metal of metal slurry 68 with carbon of carbon layer 66 may be performed under stoichiometric excess of the metal, such that the resulting metal carbide antioxidant layer 56 is metal-rich. Metal-rich may include a metal carbide phase that includes excess free metal. For example, a metal-rich metal carbide phase may include a stoichiometric ratio of the metal to the carbon of carbon layer 66 that is greater than 1.1, such as greater than about 1.001: 1. By performing the reaction at stoichiometric excess of the metal, the resulting antioxidant layer 56 may include excess metal. During formation of antioxidant layer 56 or during operation of article 51 (e.g., as a component), the excess metal may form a metal oxide. In some instances, such as will be described in FIG. 4E, the metal oxide may form a passivation layer that further protects substrate 52. In some instances, the metal oxide may perform a self-healing function for antioxidant layer 56. For example, the metal oxide may migrate into small cracks that may form during operation, such as due to mismatch in coefficient of thermal expansion (CTE) or volumetric expansion, and seal the cracks.

In some examples, reacting the metal of metal slurry 68 with the carbon of carbon layer 66 includes heating surface 62A of article 51 and/or surface 62B of carbon layer 66 above a melting point of the metal and maintaining a vapor pressure of the metal at surface 62A of article 51 and/or surface 62B of carbon layer 66 in stoichiometric excess. A variety of parameters, such as a temperature at surface 62A and/or surface 62B, a concentration (e.g., as indicated by pressure) of the metal at surface 62A and/or surface 62B, and a time of reaction, may be controlled to maintain the metal at stoichiometric excess and encourage migration of the metal into, and reaction with, carbon layer 66. As one example, for a metal of silicon, the temperature may be maintained at greater than about 1400°C, the pressure may be maintained at about 0.1 mTorr to about 300 mTorr, and the temperature and pressure may be maintained for greater than about one hour.

Referring to FIG. 5, system 80 may include a furnace 90 configured to enclose article 51. Furnace 90 may include one or more heaters configured to heat metal particles of metal slurry 68 above the melting point of the metal. Furnace 90 may be configured to maintain a temperature and pressure of the metal such that the metal maintains stoichiometric excess to form a dense layer 56. In some instances, furnace 90 may be configured to heat article 51 to conductively heat metal slurry 68. For example, while not shown in FIG. 5, one or more heaters or electrical contacts may be configured to heat (or generate heat within) article 51 to heat metal slurry 68 and react the metal of metal slurry 68 with the carbon of carbon layer 66.

Referring back to FIG. 3, in some examples, the example technique includes forming a metal oxide layer on the high temperature antioxidant coating (76). FIG. 4E is a cross-sectional side view diagram illustrating the portion of the example composite article 51 of FIG. 4A, an antioxidant layer 56, and an outer layer 58, according to examples of the disclosure. Metal slurry 68 of FIG. 4C may include metal particles coated by a layer of a metal oxide, such a silicon oxide, titanium oxide, and/or tungsten oxide. During heating of surface 62, at least a portion of the metal oxide from the metal particles may go into solution and migrate from the respective metal slurry 68 to a surface of antioxidant layer 56. Upon cooling, the metal oxide may form outer layer 58 of the metal oxide on antioxidant layer 56. In some examples, rather than or in addition to forming outer oxide layer 56, at least a portion of the metal oxide may remain in antioxidant layer 56, such that, during operation of a component that includes substrate 52, the metal oxide may be available to migrate to one or more cracks formed in antioxidant layer 56.

Example 1: A method for forming a coating includes depositing a carbon layer on to a surface of a composite article using chemical vapor deposition (CVD), wherein the composite article includes a composite substrate that includes a carbon matrix, and wherein the surface of the composite article includes one or more surface voids; applying a metal slurry to a surface of the carbon layer following the deposition of the carbon layer; and reacting a metal of the metal slurry with carbon of the carbon layer to form an antioxidant layer of a metal carbide on the composite article.

Example 2: The method of example 1, wherein the composite substrate comprises a carbon/carbon (C/C) composite substrate.

Example 3: The method of any of examples 1 and 2, wherein a thickness of the carbon layer is less than about 20 microns.

Example 4: The method of any of examples 1 through 3, wherein the carbon of the carbon layer has a different microstructure than carbon of the carbon matrix of a surface portion of the composite article.

Example 5: The method of any of examples 1 through 4, wherein, after reacting the metal of the metal slurry with carbon of the carbon layer, at least a portion of the carbon layer is unreacted.

Example 6: The method of any of examples 1 through 5, further comprising machining the surface of the composite substrate prior to depositing the carbon layer.

Example 7: The method of any of examples 1 through 6, wherein the antioxidant layer is a metal-rich antioxidant layer, and wherein the metal of the metal slurry is maintained at stoichiometric excess during the reaction of the metal with the carbon to form the metal-rich antioxidant layer.

Example 8: The method of any of examples 1 through 7, wherein the metal slurry comprises metal particles coated by a layer of a metal oxide, and wherein the method further comprises forming an outer layer of the metal oxide on the metal-rich antioxidant layer using at least a portion of the metal oxide from the metal slurry.

Example 9: The method of any of examples 1 through 8, wherein the carbon layer is deposited on a surface of the composite substrate.

Example 10: The method of any of examples 1 through 9, wherein the antioxidant layer comprises a first antioxidant layer that includes a first metal carbide, wherein the composite article further comprises a second antioxidant layer overlying a surface of the composite substrate, and wherein the second antioxidant layer includes a second metal carbide.

Example 11: The method of example 10, further comprising forming, prior to depositing the carbon layer, the second antioxidant layer from a surface portion of the carbon matrix of the composite substrate.

Example 12: A high temperature article includes a composite substrate that includes a carbon matrix; and a coating on a surface of the composite substrate, wherein the coating comprises a metal-rich antioxidant layer of a metal carbide on the surface of the composite substrate, wherein the metal carbide of the metal-rich antioxidant layer is formed from carbon of a carbon layer deposited using chemical vapor deposition, and wherein the metal-rich antioxidant layer extends into one or more surface voids of the surface of the composite substrate.

Example 13: The high temperature article of example 12, wherein the composite substrate comprises a carbon/carbon (C/C) composite substrate.

Example 14: The high temperature article of any of examples 12 and 13, wherein the carbon of the carbon layer has a different microstructure than carbon of the carbon matrix of a surface portion of the composite substrate.

Example 15: The high temperature article of any of examples 12 through 14, wherein the coating further comprises an unreacted portion of the carbon layer between the metal carbide and the surface of the composite substrate.

Example 16: The high temperature article of any of examples 12 through 15, wherein the metal carbide comprises at least one of silicon carbide, titanium carbide, or tungsten carbide.

Example 17: The high temperature article of any of examples 12 through 16, further comprising an outer layer of a metal oxide on the coating.

Example 18: The high temperature article of any of examples 12 through 17, wherein the metal carbide includes a stoichiometric ratio of a metal carbide phase of the metal to the carbon of the carbon layer that is greater than 1:1.

Example 19: The high temperature article of any of examples 12 through 18, wherein the coating is directly overlying a surface of the composite substrate.

Example 20: The high temperature article of any of examples 12 through 19, wherein the antioxidant layer comprises a first antioxidant layer that includes a first metal carbide, wherein the composite article further comprises a second antioxidant layer overlying a surface of the composite substrate, and wherein the second antioxidant layer includes a second metal carbide.

Various examples have been described. These and other examples are within the scope of the following claims.

## Claims

1. A method for forming a coating, comprising:
depositing a carbon layer on to a surface of a composite article using chemical vapor deposition (CVD), wherein the composite article includes a composite substrate that includes a carbon matrix, and wherein the surface of the composite article includes one or more surface voids;
applying a metal slurry to a surface of the carbon layer following the deposition of the carbon layer; and
reacting a metal of the metal slurry with carbon of the carbon layer to form an antioxidant layer of a metal carbide on the composite article.

2. The method of claim 1, wherein the composite substrate comprises a carbon/carbon (C/C) composite substrate.

3. The method of claim 1 or 2, wherein a thickness of the carbon layer is less than about 20 microns.

4. The method of any of claims 1 to 3, wherein the carbon of the carbon layer has a different microstructure than carbon of the carbon matrix of a surface portion of the composite article.

5. The method of any of claims 1 to 4, wherein, after reacting the metal of the metal slurry with carbon of the carbon layer, at least a portion of the carbon layer is unreacted.

6. The method of any of claims 1 to 5, further comprising machining the surface of the composite substrate prior to depositing the carbon layer.

7. The method of any of claims 1 to 6,
wherein the antioxidant layer is a metal-rich antioxidant layer, and
wherein the metal of the metal slurry is maintained at stoichiometric excess during the reaction of the metal with the carbon to form the metal-rich antioxidant layer.

8. The method of any of claims 1 to 7,
wherein the metal slurry comprises metal particles coated by a layer of a metal oxide, and
wherein the method further comprises forming an outer layer of the metal oxide on the metal-rich antioxidant layer using at least a portion of the metal oxide from the metal slurry.

9. A high temperature article, comprising:
a composite substrate that includes a carbon matrix; and
a coating on a surface of the composite substrate, wherein the coating comprises a metal-rich antioxidant layer of a metal carbide on the surface of the composite substrate,
wherein the metal carbide of the metal-rich antioxidant layer is formed from carbon of a carbon layer deposited using chemical vapor deposition, and
wherein the metal-rich antioxidant layer extends into one or more surface voids of the surface of the composite substrate.

10. The high temperature article of claim 9, wherein the composite substrate comprises a carbon/carbon (C/C) composite substrate.

11. The high temperature article of claim 9 or 10, wherein the carbon of the carbon layer has a different microstructure than carbon of the carbon matrix of a surface portion of the composite substrate.

12. The high temperature article of any of claims 9 to 11, wherein the coating further comprises an unreacted portion of the carbon layer between the metal carbide and the surface of the composite substrate.

13. The high temperature article of any of claims 9 to 12, wherein the metal carbide comprises at least one of silicon carbide, titanium carbide, or tungsten carbide.

14. The high temperature article of any of claims 9 to 13, further comprising an outer layer of a metal oxide on the coating.

15. The high temperature article of any of claims 9 to 14, wherein the metal carbide includes a stoichiometric ratio of a metal carbide phase of the metal to the carbon of the carbon layer that is greater than 1: 1.
